# EUROPÄISCHE PATENTSCHRIFT

(11) **EP 0 864 119 B1**
(45) Veröffentlichungstag und Bekanntmachung des Hinweises auf die Patenterteilung: **14.02.2001**
(21) Anmeldenummer: 96941630.4
(22) Anmeldetag: 27.11.1996
(51) Int. Cl.: G03F 7/039

(54) **PHOTOEMPFINDLICHE ZUSAMMENSETZUNG**
PHOTOSENSITIVE COMPOSITION
COMPOSITION PHOTOSENSIBLE

(30) Priorität: 28.11.1995 DE 19546140
(43) Veröffentlichungstag der Anmeldung: 16.09.1998
(73) Patentinhaber: ATOTECH Deutschland GmbH, 10553 Berlin (DE)
(72) Erfinder: MEYER, Heinrich, D-14109 Berlin (DE); URRUTIA DESMAISON, Gonzalo, D-10587 Berlin (DE); MEUNIER, Gilles, F-64230 Mazerolles (FR); PIRRI, Rosangela, F-64121 Serres-Castet (FR); VERZARO, Francis, F-64121 Serres-Castet (FR)
(74) Vertreter: Effert, Bressel und Kollegen
(86) Internationale Anmeldenummer: EP9605313
(87) Internationale Veröffentlichungsnummer: WO9720254

(56) Entgegenhaltungen:
- EP-A- 0 489 560
- EP-A- 0 605 124
- EP-A- 0 619 522

## Beschreibung

Die Erfindung betrifft photoempfindliche Zusammensetzungen und deren Verwendung als Ätz- oder Galvanoresist zur Strukturierung von Metallschichten auf elektrischen Schaltungsträgern.

Zur Strukturierung von Metallschichten, beispielsweise Kupferschichten auf Leiterplattenlaminaten, werden vorzugsweise photoempfindliche Lacke oder Folien verwendet, die die Kupferschichten beim Ätzen abdecken, so daß diese gegenüber den Ätzlösungen geschützt werden (Panel-Plating-Verfahren, Print-and-Etch-Verfahren). In diesem Fall dienen diese Resiste als Ätzschutz. Hierzu werden die Leiterplattenoberflächen oder die für die Leiterplatteninnenlagen dienenden Laminate mit dem Resistfilm beschichtet, anschließend mit dem Leiterbild belichtet, entwickelt und die freigelegten Kupferflächen durch Ätzen entfernt. Anschließend kann der als Ätzmaske verwendete Resist wieder entfernt werden.

In einer anderen Verfahrensweise (Pattern-Plating-Verfahren) werden die Resiste vor dem weiteren Metallaufbau auf die zu beschichtenden Substrate aufgebracht (Galvanoresiste) und anschließend mit dem Leiterbild belichtet und entwickelt. Danach kann auf den freigelegten Kupferflächen weiteres Metall abgeschieden werden.

In der Vergangenheit wurden zur Strukturierung der Leiterzugstrukturen überwiegend Resisttypen eingesetzt, die nach dem Belichten mit der zu erzeugenden Metallstruktur mittels organischer Lösungsmittel entwikkelt wurden. Hierbei wurden vorzugsweise Lösungsmittel eingesetzt, die neben Wasser zusätzlich Ester, organische Carbonate, Ether oder Acetate enthielten. In neuerer Zeit haben sich die mittels wäßrig-alkalischer Lösungen entwickelbaren Resisttypen durchgesetzt, da diese Entwicklungslösungen bei der Abwasserbehandlung einfacher zu handhaben sind. Außerdem bieten sie auch Vorteile hinsichtlich der zum Schutz des Bedienungspersonals zu ergreifenden Maßnahmen, da keine flüchtigen organischen, gesundheitsschädlichen Verbindungen in den Lösungen enthalten sind.

Üblicherweise werden sogenannte Negativresiste verwendet, die durch die Belichtung ausgehärtet werden, so daß beim nachfolgenden Entwickeln die Resistbereiche entfernt werden können, die nicht belichtet wurden. Der Nachteil der Negativresiste besteht darin, daß erst nach der Photohärtung die Schutzwirkung des Resists entsteht. Beispielsweise können Staubpartikel die Photohärtung beim Belichten an bestimmten Stellen verhindern, so daß an diesen Stellen beim Entwickeln Löcher in der Resistfläche entstehen. Diese Fehleranfälligkeit kann durch Anwendung größerer Resistschichtdicken vermieden werden. Allerdings sinkt dann beispielsweise die optische Auflösung des Resists durch Streulichteffekte in der Resistschicht. Eine andere Möglichkeit zur Beseitigung des Problems besteht darin, die Reinheit der Raumluft zu erhöhen. Jedoch ist dies außerordentlich aufwendig und damit teuer. Daher müssen Leiterplatten, die mit einem Negativresist hergestellt werden, in besonderem Maße auf Fehler untersucht werden, möglicherweise sogar innerhalb des Fertigungsprozesses nach der Belichtung und Entwicklung des Resists, um derartige Fehlstellen aufzufinden.

Ferner können Negativresiste zum Einsatz beim Panel-Plating-Verfahren nur als Folie eingesetzt werden und die in den Leiterplatten enthaltenen Löcher dadurch gegen die Kupfer-Ätzlösungen schützen, daß die Resistfolie die Locheingänge überspannt (Tenting-Verfahren). Eine alternative Verfahrensweise, bei der der Negativresist auf die Lochwände direkt aufgebracht wird und dort auch während des nachfolgenden Kupfer-Ätzverfahrens zum Schutz der Kupferschichten verbleibt, ist dagegen nicht praktikabel, da der Resist hierzu in den Löchern belichtet werden müßte. Dies ist jedoch nicht zuverlässig möglich, insbesondere nicht bei kleineren Löchern mit rauhen Lochwänden. Beim Tenting-Verfahren ist es erforderlich, daß die Resistfolienbereiche, die die Löcher überspannen, eine ausreichend große Auflagefläche um die Locheingänge herum aufweisen, so daß an diesen Stellen auch beim nachfolgenden Ätzen ein Kupferring um die Locheingänge herum entsteht, der jedoch unnötige Fläche auf der Leiterplatte beansprucht.

Bei der Anwendung eines Positivresists, bei dem der auf die zu strukturierenden Flächen aufgebrachte Film in den Entwicklungslösungen zunächst unlöslich ist und erst durch die Belichtung in einen löslichen Zustand überführt wird, bestehen die genannten Probleme in weit geringerem Umfange.

Insbesondere ist es mit Positivresisten möglich, beim Panel-Plating-Verfahren Löcher in Leiterplatten zu metallisieren, ohne daß noch Restringe um die Locheingänge herum zurückbleiben. Dadurch werden wesentlich feinere Schaltungsmuster ermöglicht.

Ferner hat es sich herausgestellt, daß mit Positivresisten eine bessere optische Auflösung durch genauere Abbildung der Strukturkanten erreicht werden kann.

Die Wirkungsweise der Negativ- und Positivresiste ist in W.M. Moreau, Semiconductor Lithography, Plenum Press, 1988, näher erläutert.

Typische Positiv-Photoresiste enthalten als Polymere üblicherweise Novolake. Beispielsweise werden derartige Resiste in US-PS 52 66 440 beschrieben.

Diese Photoresiste sind jedoch relativ wenig lichtempfindlich, so daß lange Belichtungszeiten oder hohe Lichtintensitäten in Kauf genommen werden müssen. Beispielsweise sind zur Belichtung von Leiterplatten, die mit herkömmlichen Positivresisten beschichtet sind, Lichtintensitäten von etwa 350 mJ/cm² erforderlich, während bei der Verwendung von Negativresisten üblicherweise Werte von etwa 100 mJ/cm² ausreichen (vgl. H. Nakahara, Electronic Packaging & Production, 1992, Seiten 66 ff.).

In neuerer Zeit werden Positivresiste beschrieben, deren Lichtempfindlichkeit auf photokatalysierter Protonenabspaltung von bestimmten organischen Säuren und nachfolgender Säurespaltung von Seitengruppen des den Resist bildenden Polymeren unter Bildung von in wäßrigalkalischen Lösungen löslicher Verbindungen beruht. Die Lichtempfindlichkeit dieser Resisttypen ist deutlich höher als die der vorgenannten Typen.

Das Prinzip dieser als "Photoresiste mit chemischer Verstärkung (Amplifikation - "chemically amplified photoresists") bezeichneten Resiste ist in G.M. Wallraff et al., "Designing tomorrow's photoresists", Chemtech, 1993, Seiten 22 bis 30, beschrieben. Danach werden als durch UV-Bestrahlung spaltbare Säuregeneratoren organische Oniumsalze, beispielsweise Diphenyliodonium-hexafluoroantimonat, verwendet. Als säurespaltbare Polymere werden vorzugsweise Polyacrylate verwendet, die tert.-Butylgruppen als Carbonsäureester-Seitengruppen enthalten, welche durch die Säurekatalyse abgespalten werden. Dabei entstehen polare Carbonsäure-Seitengruppen, die die höhere Löslichkeit des Polymeren in wäßriger Lösung verursachen.

In US-PS 44 91 628 ist eine nach dem vorgenannten Prinzip arbeitende Resistzusammensetzung offenbart, die neben dem Säuregenerator ein säurespaltbares Polymer enthält. Als Polymer werden Verbindungen mit Phenolen oder Styrolen mit tert.-Butylester-Gruppen, beispielsweise Poly-(tert.-Butoxycarbonyloxystyrol) vorgeschlagen. Als Säuregeneratoren werden Diaryliodonium- und Triarylsulfonium-Metallhalogenide verwendet.

In EP 0 445 058 A1 sind durch Säurespaltung katalysierte Photoresiste beschrieben, die neben einem Säuregenerator säurespaltbare Polymere, beispielsweise Polystyrole mit tert.-Butoxycarbonyloxy-Gruppen, enthalten. Als Säuregeneratoren werden organische Oniumsalze, beispielsweise Aryldiazonium-, Diaryliodonium- und Triarylsulfonium-Metallhalogenide, vorgeschlagen.

In EP 0 568 827 A2 ist eine bildgebende Zusammensetzung beschrieben, die auch elektroabscheidbar ist und die neben einem Säuregenerator zusätzlich Polystyrole als säurespaltbare Polymere, nämlich Phenolharze, beispielsweise Novolake mit tert.-Butoxycarbonyloxy-Gruppen, enthält.

In US-PS 52 72 042 werden Positivresiste beschrieben, die ebenfalls Polystyrole mit tert.-Butoxycarbonylgruppen enthalten, sowie solche, die als säurespaltbare Polymere Polyacrylate mit tert.-Butoxycarbonylgruppen als Seitengruppen enthalten. Als Säuregeneratoren werden N-Hydroxyamide und -imide, beispielsweise N-Trifluoromethylsulfonyloxynaphthalimid, verwendet. Um den Photoresist auch für sichtbares Licht empfindlich zu machen, wird zusätzlich ein Anthracenderivat als Photosensibilisator, beispielsweise 9,10-Bis-(Trimethylsilylethinyl)-anthracen, eingesetzt.

In US-PS 50 71 730 wird ebenfalls ein Positivresist beschrieben, der neben einem Säuregenerator (Aryldiazonium-, Diaryliodonium-, Triarylsulfonium-Metallhalogenid) und Photosensibilisatoren (Pyren, Perylen) ein säurespaltbares Polymer enthält. Als Polymer wird ein Polyacrylat vorgechlagen, das aus drei verschiedenen Acrylaten gebildet ist, nämlich tert.-Butylacrylat bzw. -methacrylat, Methylacrylat bzw. -methacrylat und Acryl- bzw. Methacrylsäure.

In US-PS 50 45 431 wird eine dem vorgenannten Resist sehr ähnliche Zusammensetzung offenbart, dessen Polymeres ebenfalls aus Acrylatverbindungen gebildet ist und als mögliche zusätzliche Acrylateinheiten in der Polymerkette Ethylacrylat oder Butylacrylat enthält.

In US-PS 52 30 984 ist eine zur Bildung eines mittels Elektrophorese abscheidbaren Photoresistes dienende Harzzusammensetzung offenbart, die aus Acryl- oder Methacrylsäure, ferner tert.-Alkylacrylat oder -methacrylat und ferner einem polymerisierbaren Monomer besteht, wobei letzteres als Homopolymer eine Glasübergangstemperatur von 0 °C oder niedriger zu bilden imstande ist. Als derartige Monomere werden u.a. Ethylacrylat, Propylacrylate, iso-Butylacrylat und höhere Homologe angegeben. Als Photosäuregeneratoren werden u.a. Phosphonium-, Sulfonium-, Diazonium-, lodoniumsalze und Oxazolderivate vorgeschlagen.

Es hat sich herausgestellt, daß die bekannten Positivresiste, die auf die Kupferflächen von Leiterplatten aufgetragen werden, beim Entwickeln der belichteten Bereiche nicht restlos von den Kupferflächen entfernt werden können. Auch durch eine verlängerte Belichtungszeit oder erhöhte Lichtintensität beim Belichten können Rückstände auf den Kupferflächen nicht vollständig beseitigt werden, zumindest dann nicht, wenn die Resistschicht mit den zum Erreichen eines befriedigenden Belichtungsergebnisses erforderlichen Parametern (Belichtungszeit, Lichtintensität) beim Belichten behandelt wird. Insbesondere kann eine direkt an der Kupferoberfläche anliegende Resistschicht beim Entwikkeln nicht vollständig und sicher entfernt werden, so daß sich beim nachfolgenden Ätzen beim Panel-Plating-Verfahren oder beim nachfolgenden elektrolytischen Metallisieren beim Pattern-Plating-Verfahren Probleme ergeben. Die nicht entfernbaren Rückstände führen zu mangelhafter Haftfestigkeit der nachfolgend abgeschiedenen Metallschicht auf den Kupferflächen bzw. zu unbefriedigenden Ätzergebnissen, da die Rückstände den Ätzprozeß behindern. Im ungünstigsten Fall scheiden sich an diesen Stellen überhaupt keine weiteren Metallschichten mehr ab, bzw. es wird die Kupferschicht beim Ätzprozeß überhaupt nicht angegriffen. Derartige Probleme treten bei der Strukturierung von Halbleitersubstraten nicht auf.

Darüber hinaus ist der Kontrast zwischen belichteten und unbelichteten Stellen bei den herkömmlichen Photoresisten teilweise nur unbefriedigend gering, so daß die Kantenschärfe nicht ausreichend ausgebildet ist. Außerdem weisen die bekannten Resistschichten keine hinreichende Chemikalienbeständigkeit vor allem gegen saure Ätzlösungen auf, da häufig ein Kompromiß zwischen ausreichend leichter Entwickelbarkeit in alkalischen Lösungen und der Chemikalienbeständigkeit gefunden werden mußte. Im übrigen leiden die bekannten Resiste auch an einer erhöhten Anfälligkeit gegen die Einwirkung von Staub und anderen Verunreinigungen, die sich beim Belichten auf die Resistschichten ablagern und dort die Belichtung behindern. Bei den Positivresisten führen derartige Kontaminationen üblicherweise zu unentwickelten Stellen in den belichteten Bereichen, so daß bei der Leiterplattenherstellung die Metallabscheidung in diesen Bereichen dann nicht vonstatten geht. Bei der Herstellung von Halbleiterschaltungen spielt diese erhöhte Defekthäufigkeit keine übergeordnete Rolle, da ohnehin mit höchstgereinigter Raumluft gearbeitet wird. Höchste Anforderungen an die Reinheit der Raumluft können bei der Leiterplattenherstellung jedoch nicht erfüllt werden.

Das der vorliegenden Erfindung zugrunde liegende Problem besteht von daher darin, die Nachteile der bekannten Verfahren zu vermeiden und insbesondere eine Resistzusammensetzung bereitzustellen, die beim Entwickeln rückstandsfrei von den Kupferflächen, beispielsweise einer Leiterplatte, entfernt werden kann, so daß die weiteren Behandlungsschritte ohne Beeinträchtigung durch Rückstände des Photoresists durchgeführt werden können. Ferner muß auch gewährleistet sein, daß die Photoresistschicht auf den Kupferflächen ausreichend gut haftet. Insbesondere muß die nicht belichtete und beim nachfolgenden Entwicklungsprozeß nicht entfernte Resistschicht auch weitere chemische Behandlungsschritte ohne Beschädigungen überstehen, einen guten Kontrast zwischen belichteten und unbelichteten Bereichen aufweisen und möglichst unempfindlich gegen Kontaminationen beim Entwickeln sein.

Gelöst wird das Problem durch photoempfindliche Zusammensetzungen gemäß den Patentsprüchen 1, 4, 5, und 6. Vorteilhafte Ausführungsformen der Erfindung sind in den Unteransprüchen angegeben.

Die erfindungsgemäßen Resistvarianten enthalten neben mindestens einem Photosäuregenerator ein Polymer mit säurespaltbaren Seitengruppen, das durch die beim Belichten freigesetzte Säure des Photosäuregenerators in einen löslichen Zustand überführt wird.

Das Polymer, vorzugsweise Copolymer, ist aus verschiedenen Monomeren gebildet, um die erfindungsgemäße Aufgabe zu lösen. Das Polymer ist aus folgenden auf das Polymer bezogenen Anteilen an Monomeren gebildet:

### 1. Variante:

A - Monomere, ausgewählt aus der Gruppe der Verbindungen Acrylsäure und Methacrylsäure, mit einem Anteil von 8 Mol-% bis 20 Mol-%,
B - Monomere, ausgewählt aus der Gruppe der Verbindungen tert.-Butylacrylat und tert.-Butylmethacrylat, mit einem Anteil von 19 Mol-% bis 70 Mol-% und
C - Monomere, ausgewählt aus der Gruppe der Verbindungen Hydroxyethylmethacrylat, Hydroxypropylmethacrylat, Hydroxyphenylmethacrylat, Hydroxyethylacrylat, Hydroxypropylacrylat und Hydroxyphenylacrylat, mit einem Anteil von 1 Mol-% bis 30 Mol-%.

Das säurespaltbare Polymer kann zusätzlich zu den vorgenannten Monomeren
D - Monomere, ausgewählt aus der Gruppe der Verbindungen Methylacrylat und Methylmethacrylat, mit einem Anteil von 10 Mol-% bis 60 Mol-%
enthalten.

Außerdem kann das säurespaltbare Polymere zusätzlich zu den vorgenannten Monomeren A, B, C und D ferner
E - Monomere, ausgewählt aus der Gruppe der Verbindungen mit der allgemeinen Formel

CH₂ = CR¹-COOR²,

wobei
R¹ ein Wasserstoffatom oder eine Methylgruppe und
R² eine lineare oder verzweigte Alkylgruppe mit mindestens drei Kohlenstoffatomen ist,
mit einem Anteil von 3 Mol-% bis 35 Mol-%
enthalten.

### 2. Variante:

A - Monomere, ausgewählt aus der Gruppe der Verbindungen Acrylsäure und Methacrylsäure, mit einem Anteil von 10 Mol-% bis 25 Mol-%,
B - Monomere, ausgewählt aus der Gruppe der Verbindungen tert.-Butylacrylat und tert.-Butylmethacrylat, mit einem Anteil von 17 Mol-% bis 40 Mol-%,
D - Monomere, ausgewählt aus der Gruppe der Verbindungen Methylacrylat und Methylmethacrylat, mit einem Anteil von 20 Mol-% bis 60 Mol-% und
E - Monomere, ausgewählt aus der Gruppe der Verbindungen mit der allgemeinen Formel

   CH₂ = CR¹-COOR²,

   wobei
   R¹ ein Wasserstoffatom oder eine Methylgruppe und
   R² eine lineare oder verzweigte Alkylgruppe mit mindestens fünf Kohlenstoffatomen ist,
   mit einem Anteil von 1 Mol-% bis 35 Mol-%.

### 3. Variante:

A - Monomere, ausgewählt aus der Gruppe der Verbindungen Acrylsäure und Methacrylsäure, mit einem Anteil von 14 Mol-% bis 20 Mol-%,
B - Monomere, ausgewählt aus der Gruppe der Verbindungen tert.-Butylacrylat und tert.-Butylmethacrylat, mit einem Anteil von 20 Mol-% bis 32 Mol-%,
D - Monomere, ausgewählt aus der Gruppe der Verbindungen Methylacrylat und Methylmethacrylat, mit einem Anteil von 30 Mol-% bis 50 Mol-% und
E - Monomere, ausgewählt aus der Gruppe der Verbindungen mit der allgemeinen Formel

   CH₂ = CR¹-COOR²,

   wobei
   R¹ ein Wasserstoffatom oder eine Methylgruppe und
   R² eine lineare oder verzweigte Alkylgruppe mit mindestens zwei Kohlenstoffatomen ist, und
   die Monomeren E mit den Monomeren B nicht identisch sind,
   mit einem Anteil von 10 Mol-% bis 40 Mol-%,
   wobei die Summe der Anteile der Monomere A, B, D und E im Polymer 100 Mol-% beträgt.

### 4. Variante:

A - Monomere, ausgewählt aus der Gruppe der Verbindungen Acrylsäure und Methacrylsäure, mit einem Anteil von 13 Mol-% bis 15 Mol-%,
B - Monomere, ausgewählt aus der Gruppe der Verbindungen tert.-Butylacrylat und tert.-Butylmethacrylat, mit einem Anteil von 22,5 Mol-% bis 30 Mol-% und
D - Monomere, ausgewählt aus der Gruppe der Verbindungen Methylacrylat und Methylmethacrylat, mit einem Anteil von 50 Mol-% bis 65 Mol-%,
wobei die Summe der Anteile der Monomere A, B und D im Polymer 100 Mol-% beträgt.

Mit den vorgenannten Zusammensetzungen, die neben dem Photosäuregenerator mindestens eines der beschriebenen Polymeren enthält, werden Photoresiste mit folgenden Eigenschaften erhalten:
a. Im belichteten Zustand kann die Resistschicht problemlos durch Entwicklungslösungen von der darunterliegenden Kupferschicht entfernt werden. Es bleiben keine Rückstände auf der Kupferoberfläche zurück. Dadurch daß das Polymere tert.-Butylacrylat- und/oder -methacrylat enthält, steigt die Löslichkeit der Resistschicht im belichteten Zustand in wäßrigen Entwicklungslösungen an.
b. Im unbelichteten Zustand widerstehen die Resiste den in einem galvanotechnischen Prozeßablauf üblichen Behandlungslösungen. Insbesondere weist die Resistschicht eine hohe Haftfestigkeit zur Kupferschicht einer Leiterplatte auf. Durch den Carbonsäureanteil im Polymeren, nämiich den Anteil an Acrylsäure und Methacrylsäure, steigt die Haftfestigkeit des Resists auf der Kupferoberfläche, so daß dadurch die Gefahr von Unterwanderungen der Resistschicht durch Chemikalien verringert wird. Andererseits wird die Löslichkeit des Resists in wäßrigen Entwicklungslösungen bei verringertem Carbonsäureanteii im Polymeren verringert.
   Durch Verwendung hydrophober Monomerenbestandteile im Polymeren, die in der Seitenkette des Acrylats gemäß der 1. Polymervariante mindestens drei Kohlenstoffatome enthalten, wird die Widerstandskraft der unbelichteten Zusammensetzung gegen chemische Behandlungsmittel (wäßrige Behandlungslösungen mit pH-Werten von 0 bis 13) verstärkt. Dieselbe Abstimmung der belichteten und unbelichteten Bereiche im erfindungsgemäßen Photoresist kann weiterhin dadurch erzielt werden, daß die Balance zwischen Gehalt an hydrophilen und hydrophoben Bestandteilen (auch Seitenketten mit mindestens zwei Kohlenstoffatomen) im Polymeren mit weiteren Monomeren eingestellt wird. Durch die erfindungsgemäßen Polymeren wird dadurch ein erhöhter Kontrast der Resiste beim Belichten sowie eine außerordentlich hohe Chemikalienbeständigkeit der entwickelten Schichten erreicht. Beispielsweise übersteht eine entwickelte Schicht des erfindungsgemäßen Resists auf mit einer Kupferkaschierung belegten Leiterplatte auch eine mehrere Stunden andauernde Lagerung in einer zum Ätzen von Kupfer üblicherweise verwendeten salzsauren Kupfer-(II)-chlorid-Lösung. Zwar bilden sich in diesem Fall an den Flanken der ausentwickelten Strukturen Unterätzungen, die durch seitlichen Angriff des Ätzmittels auf die Kupferkaschierung entstehen. Jedoch haftet die Resistschicht auf der Kupferkaschierung im übrigen fehlerfrei.
c. Darüber hinaus wird eine wesentlich geringere Defektrate als mit herkömmlichen Resisten erreicht, die durch Staubkontamination und durch andere Verunreinigungen der Resistoberfläche beim Entwickeln verursacht wird.
d. Ferner kann die unbelichtete Resistschicht durch geeignete Lösungen (Strippern) von der Substratoberfläche wieder entfernt werden.
e. Die Resiste weisen eine hohe Lichtempfindlichkeit auf. Die erfindungsgemäßen Polymeren haben ferner den Vorteil einer hohen Transparenz, so daß Licht in der Resistschicht nur wenig gestreut wird. Dadurch wird eine hohe Kantenschärfe bei der Belichtung und anschließenden Entwicklung ermöglicht, die zu hervorragender Abbildungsschärfe und ausgezeichnetem optischen Auflösungsvermögen führt. Der Kontrast beim Entwickeln des Resists steigt mit dem Anteil an tert.-Butylacrylat bzw. -methacrylat.
f. Durch geeignete Zusammensetzung des Polymeren aus bestimmten Monomeren werden Polymere mit einer geeigneten Glasübergangstemperatur T_{g} zwischen 40 °C und 150 °C ermöglicht. Da die erfindungsgemäße photoempfindliche Zusammensetzung beim Auftragsprozeß auf die zu strukturierenden Oberflächen erwärmt wird, können die entstehenden Schichten durch teilweises Erweichen als gleichmäßig dicke Filme gebildet werden, die frei von Luftblasen, Einschlüssen oder anderen störenden Verunreinigungen sind. Außerdem wird durch eine Glasübergangstemperatur im angegebenen Bereich eine im kalten Zustand mechanisch widerstandsfähige und im warmen Zustand flexible Resistschicht ermöglicht.
   Die im angegebenen Bereich liegenden Glasübergangstemperaturen der Resistschichten ermöglichen ferner eine problemlose Übertragung der auf polymere Trägerfilme aufgetragenen Resistschichten auf die Substratoberfläche zur Anwendung als Trockenresiste. Eine zu niedrige Glasübergangstemperatur würde ferner dazu führen, daß die Zusammensetzung unbrauchbare Abbildungen liefern würde. Eine zu hohe Temperatur würde zu zu hoher Festigkeit der Resistschicht sowie zu sehr hohen Transfertemperaturen (Übertragung der Resistschicht von einem Träger auf das Substrat) und Glättungstemperaturen führen.
g. Die aus den erfindungsgemäßen Zusammensetzungen gebildeten Resistschichten können durch wäßrig-alkalische Lösungen entwickelt bzw. vollständig entfernt werden. Organische Lösungsmittel sind nicht erforderlich, insbesondere keine chlorierten Kohlenwasserstoffe.

Die photoempfindlichen Polymeren weisen ein mittleres Molekulargewicht M_{w} von 30.000 bis 90.000, vorzugsweise von 35.000 bis 82.000, auf.

Die Molekulargewichtsverteilung der Polymeren kann durch einen Polymolekularitätsindex Pl beschrieben werden, der das Verhältnis des mittleren Molekulargewichts M_{w} des Polymeren zum Zahlenmittel des Molekulargewichts Mₙ angibt. Der Polymolekularitätsindex Pl beschreibt die Breite der Molekulargewichtsverteilung (vergleiche hierzu auch M. Hoffmann, H. Kröner, R. Kuhn in Polymeranalytik I, Seite 34, G. Thieme Verlag, Deutschland, 1977). Der Polymolekularitätsindex Pl der erfindungsgemäßen Polymere weist einen Wert von 1,6 bis 3,1, vorzugsweise von 2,1 bis 3,0, auf.

Diese Eigenschaften werden durch eine Vielzahl von Reaktionsparametern beeinflußt, beispielsweise durch die Wahl des Lösungsmittels, der Reaktionstemperatur und die Art des Reaktionsinitiators (beispielsweise der Peroxid-Verbindung) bei der Polymerisation der erfindungsgemäßen Monomerenmischungen. Ein Hinweis auf den Mechanismus zur Steuerung des Polymolekularitätsindex Pl ist in H.G. Glas, Makromoleküle, Seite 487, Hüthig-Verlag, Deutschland, 1990 angegeben.

Kleine Werte für den Polymolekularitätsindex spiegeln eine enge Molekulargewichtsverteilung wieder.

Als Photosäuregeneratoren können die üblichen Verbindungen eingesetzt werden, beispielsweise N-Trifluoromethylsulfonyloxynaphthalimid (NIT): 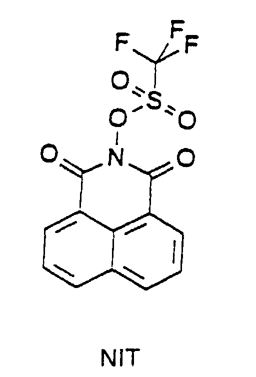 und andere Trifluormethylsulfonyloxyimid-Derivate, wie 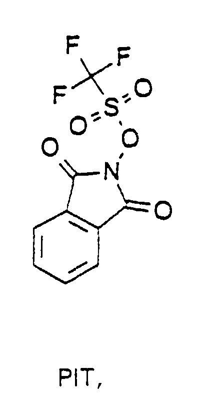 ferner Trifluoromethylsulfonyloxy-bicyclo[2.2.1 ]-hept-5-en-2,3-dicarboximid (MDT), Naphthochinon-1,2-diazid-4-sulfonsäureester, beispielsweise 1 -Naphthalinsulfonsäure-3-diazo-3,4-dihydro-4-oxoester mit Phenyl-(2,3,4-trihydroxyphenyl)-methanon. Weitere N-Trifluormethylsulfonyloxyimid-Derivate sind in J.M.J. Frechet, Pure and Appl. Chem., 64, Seiten 1239 bis 1248 sowie in US-PS 52 72 042 angegeben, beispielsweise: 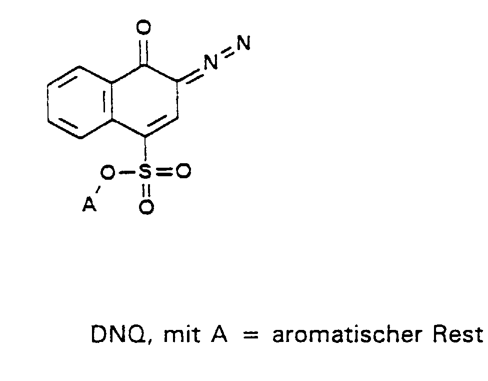 und

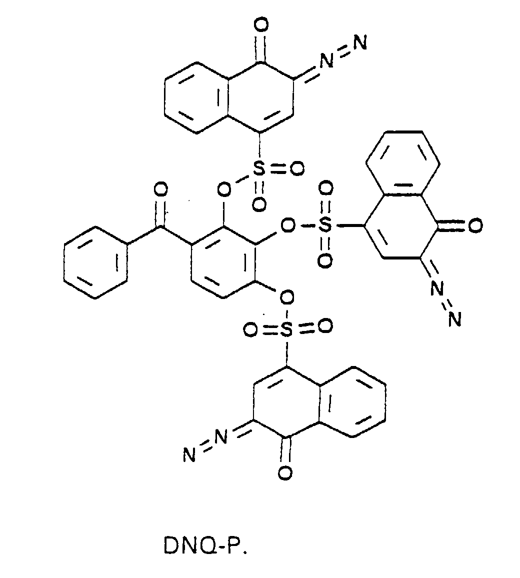

Ferner sind 1,2,3-Benzol-tris-(sulfonsäuretrifluormethylester), 1,2,3-Benzol-tris-(sulfonsäuremethylester), 6,7-Bis-(trifluormethylsulfonyloxy)-coumarin, 2,3,4-Tris-(fluormethylsulfonyloxy)-benzophenon als Photosäuregeneratoren sowie die in EP-A 0 489 560 beschriebenen Photosäuregeneratoren geeignet.

Die Synthese von Photosäuregeneratoren ist unter anderem in EP-A 0 058 638 sowie in J.M.J. Frechet, Pure and Appl. Chem., 64, Seiten 1239 bis 1248 beschrieben.

Der Gehalt der Photosäuregeneratoren in der photoempfindlichen Zusammensetzung beträgt 1 Gew.-% bis 25 Gew.-%, vorzugsweise 2 Gew.-% bis 20 Gew.-%, bezogen auf das Gewicht des Polymeren in der Zusammensetzung.

In der photoempfindlichen Zusammensetzung sind neben den Photosäuregeneratoren und dem Polymeren weitere Komponenten enthalten:

Um die Zusammensetzung auch für Licht mit bestimmter spektraler Intensitätsverteilung, vorzugsweise im sichtbaren Bereich (330 nm bis 440 nm), empfindlich zu machen, werden der Zusammensetzung ein oder mehrere Photosensibilisatoren zugegeben. Hierbei handelt es sich meist um polycyclische Aromatenverbindungen, beispielsweise Anthracen, 9-Anthracenmethanol, 1,4-Dimethoxyanthracen, 9,10-Diethylanthracen, 9-Phenoxymethylanthracen und 9,10-Bis-(ethinyl)-anthracen, wie beispielsweise 9,10-Bis-(trimethylsilylethinyl)-anthracen, durch die die Lichtempfindlichkeit der photoempfindlichen Zusammensetzungen, vorzugsweise für rotes Licht, stark erhöht wird.

Diese Photosensibilisatoren werden vorzugsweise in Konzentrationen von 1 Gew.-% bis 6 Gew.-%, vorzugsweise von 2 Gew.-% bis 4 Gew.-%, bezogen auf das Gewicht des Polymeren in der Zusammensetzung, eingesetzt.

Weiterhin können die erfindungsgemäßen Zusammensetzungen auch Farbstoffe enthalten, um die Erkennbarkeit des Resists auch in dünner Schicht auf dem zu strukturierenden Substrat zu verbessern sowie weitere für Photoresistmaterialien übliche Inhaltsstoffe.

Die als Resiste verwendbaren Zusammensetzungen werden beispielsweise als flüssige Formulierungen verwendet. Hierzu werden sie mit geeigneten Lösungsmitteln, beispielsweise Ethern, Etheralkoholen oder Etherestern, versetzt. Als Lösungsmittel werden beispielsweise Propylenglykolmonomethyletheracetat, 1-Methoxy-2-propanol, Ethyllactat, 3-Ethoxypropionat, Ethylenglykolmonoethyletheracetat, Methoxybutanol, Diethylenglykolmonoalkylether und Propylenglykolmonobutylether verwendet.

Die flüssige Zusammensetzung wird beispielsweise durch Aufschleudern auf die zu beschichtenden Oberflächen aufgetragen (Spin-Coating). Eine andere Auftragstechnik ist das Walzenbeschichtungsverfahren, bei dem die Zusammensetzung zunächst eine erste Walze in dünner Schicht benetzt, indem die Flüssigkeit mittels Abquetschwalzen in definierter Dicke auf diese Walze aufgetragen wird. Von dieser Walze wird die Schicht anschließend durch direkten Kontakt der Walze mit dem Substrat auf dieses übertragen. Auch auf großflächigen ebenen Substratoberflächen kann auf diese Weise ein gleichmäßig dicker Film gebildet werden. Üblicherweise werden Schichtdicken der Zusammensetzung von 3 µm bis 20 µm eingestellt.

Das Walzenbeschichtungsverfahren weist den Vorteil auf, daß problemlos definierte Schichtdicken des Resists auf plattenförmigen Substraten, beispielsweise Leiterplatten, eingestellt werden können. Außerdem können die Substrate in horizontaler Lage und horizontaler Richtung durch die Beschichtungsanlage hindurchgeführt werden. Derartige Beschichtungsanlagen können ohne weiteres mit anderen Horizontalanlagen für die weiteren Behandlungsschritte zur Erzeugung der Metallstrukturen verknüpft werden, so daß sich eine vereinfachte Handhabung der Substrate mit der Möglichkeit der Automatisierung ergibt.

Ferner kann die flüssige Zusammensetzung auch durch Tauchen auf das Substrat aufgetragen werden. Hierbei ist jedoch problematisch, daß sich an Kanten unterschiedliche, nicht steuerbare Schichtdicken einstellen.

Die erfindungsgemäßen Zusammensetzungen können jedoch zur Anwendung in der Trockenfilmtechnik auch auf einen polymeren Trägerfilm aufgebracht werden, beispielsweise auf eine Polyesterfolie. Von dieser wird die Zusammensetzung durch direkten Kontakt der auf der Folie aufgebrachten photoempfindlichen Schicht mit dem zu strukturierenden Substrat, beispielsweise durch Verpressen übertragen.

Nach dem Beschichten des Substrats mit der Zusammensetzung wird die gebildete Resistschicht unter Wärmeeinwirkung getrocknet, beispielsweise im Umluftofen oder mittels Infrarotstrahlung. Danach wird die Schicht mit dem Bild belichtet, danach erneut erwärmt, um die Bildung des latenten Bildes zu beschleunigen (Nachbrennen), und anschließend werden die belichteten Bereiche in der Resistschicht beim Entwickeln herausgelöst. Hierzu werden vorzugsweise Sprühanlagen verwendet, durch die die Entwicklungslösung über Düsen auf die Substratoberflächen gespritzt wird. Als Entwicklungslösungen werden vorzugsweise wäßrig-alkalische Lösungen verwendet, beispielsweise Natriumcarbonatlösung.

Die photoempfindlichen Zusammensetzungen können als Ätz- oder Galvanoresiste zur Strukturierung von Metallschichten, beispielsweise zur Herstellung von elektrischen Schaltungsträgern, eingesetzt werden. Daher schließen sich an die genannten Verfahrensschritte die weiteren Prozesse zur Herstellung der gewünschten Metallstrukturen an, beispielsweise Ätzprozesse oder weitere elektrolytische Metallabscheidungsverfahren, wobei in den gebildeten Resistkanälen die freigelegten Metallflächen mit Ätzprozessen entfernt bzw. mittels elektrolytischer Abscheidungsverfahren weiter aufgebaut werden.

Eine weitere Verwendung der photoempfindlichen Zusammensetzungen besteht in deren Anwendung als Galvanoresist bei der Additivtechnik, vorzugsweise zur Photostrukturierung von Substraten aus Epoxidharzen, Acrylnitril-Butadien-Styrol-Copolymeren (ABS) und Polyimid. Hierbei werden Metallstrukturen mittels stromloser Metallisierungsbäder in den durch Belichtung und Entwicklung gebildeten Resistkanälen hergestellt.

Nach Abschluß des Strukturierungsverfahrens wird die Resistschicht von den Substratoberflächen wieder entfernt, vorzugsweise mittels wäßrig-alkalischer Lösungen, beispielsweise einer Natronlaugelösung.

Die erfindungsgemäßen Zusammensetzungen werden zur Strukturierung von Metallschichten auf elektrischen Schaltungsträgern, beispieisweise mit Epoxidharz-, Polyimid- oder deren Composite-Laminaten, sowie zu dekorativen Zwecken auf Metall- oder Kunststoffsubstraten verwendet. In einer bevorzugten Anwendung werden die Zusammensetzungen zur Herstellung von mit Kupferflächen versehenen Leiterplatten und von für Leiterplatten vorgesehenen Innenlagen-Laminaten verwendet.

Die folgenden Beispiele dienen zur Erläuterung der Erfindung:

### Beispiel 1 (Polymersynthese zur Herstellung von Trockensubstanz) :

Zur Herstellung der erfindungsgemäßen Acrylat-Polymere wurden zunächst Tetrahydrofuran (THF) und Azo-bis-isobutyronitril (AIBN) in einen Doppelhalskolben gegeben. Anschließend wurden die Monomere zugegeben. Das Reaktionsgemisch wurde während der gesamten Reaktionsdauer unter Luftausschluß gehalten. Für die Herstellung eines erfindungsgemäßen Polymeren sind die eingesetzten Mengenverhältnisse in der nachfolgenden Tabelle angegeben:

| Komponente | Menge in Gewichtsteilen |
|---|---|
| THF | 1467 |
| AIBN | 1,956 |
| Methacrylsäure | 64,2 |
| tert.-Butylmethacrylat | 128,4 |
| Methylmethacrylat | 128,4 |
| Butylacrylat | 134,7 |
| Hydroxypropylmethacrylat | 33,3 |

Zum Start der Polymerisationsreaktion wurde die Mischung aufgeheizt. Die Mischung wurde 24 Stunden unter Rückfluß gehalten, der Umsatz betrug nach Abschluß der Reaktion 100 %.

Nach Abschluß der Reaktion wurde das Polymere mit Petroleumbenzin ausgefällt. Nach der Abtrennung wurde ein farbloses Pulver erhalten, das bei 60 °C bis 70 °C 48 Stunden lang unter Vakuum getrocknet wurde.

Mit der vorstehend beschriebenen Methode wurden ferner auch die in Tabelle 1 angegebenen Polymere hergestellt.

### Beispiel 2 (Polymersynthese zur direkten Verwendung der Reaktionslösung als Photoresist-Grundlage) :

Es wurde wie in Beispiel 1 verfahren. Allerdings wurde Propylenglykolmonomethyletheracetat (PGMEA) als Lösungsmittel anstelle von THF verwendet. Zur Herstellung des Polymeren wurden die folgenden Mengenverhältnisse der einzelnen Komponenten eingestellt:

| Komponente | Menge in Gewichtsteilen |
|---|---|
| PGMEA | 485 |
| AIBN | 0,652 |
| Methacrylsäure | 21,4 |
| tert.-Butylmethacrylat | 42,8 |
| Methylmethacrylat | 42,8 |
| Butylacrylat | 44,9 |
| Hydroxypropylmethacrylat | 11,1 |

Zum Start der Polymerisationsreaktion wurde die Mischung auf 100 °C aufgeheizt. Die Mischung wurde 26 Stunden lang erhitzt, der Umsatz betrug 100 %. Es wurde ein Polymer mit derselben Zusammensetzung wie das nach dem Verfahren gemäß Beispiel 1 hergestellte Polymer erhalten.

Mit der vorstehend beschriebenen Methode wurden ferner auch die in Tabelle 1 angegebenen Polymere hergestellt.

Anstelle der in den Beispielen 1 und 2 verwendeten Lösungsmittel bei der Polymerisation wurden auch Dioxan, Cyclohexanon oder Heptan als Lösungsmittel verwendet. Anstelle von Azo-bis-isobutyronitril (AIBN) können Benzoylperoxid oder andere radikalische Initiatoren eingesetzt werden. Die Vollständigkeit der Umsetzung ist dabei abhängig vom verwendeten Lösungsmittel, von der Reaktionstemperatur, der Art des Initiators und der Reaktionsdauer.

### Beispiel 3 (Herstellung einer flüssigen Photoresist-Zusammensetzung, Photolack):

Im Gelblichtraum wurden 30 Gewichtsteile N-Trifluoromethylsulfonyloxynaphthalimid (NIT) als Säuregenerator und 20 Gewichtsteile 9-Anthracenmethanol (AM) als Sensibilisator mit 1000 Gewichtsteilen einer Lösung von nach Beispiel 1 erhaltenem Polymer in Propylenglykolmonomethyletheracetat mit einer Lösung mit einem Feststoffgehalt von etwa 25 Gew.-% (20 bis 30 Gew.-%) gemischt.

In einer anderen Ausführungsform wurden anstelle einer 25 Gew.-%igen Polymerlösung eine 20 Gew.-%ige und eine 30 Gew.-%ige Polymerlösung verwendet.

In einem weiteren Versuch wurden anstelle von NIT und AM 200 Gewichtsteile 4-Diazonaphthochinonsulfonsäureester verwendet.

Ferner wurden auch entsprechende Polymerlösungen, die durch Auflösen der gemäß Beispiel 1 erhaltenen Polymer-Trockensubstanz in 1-Methoxy-2-propanol mit denselben Feststoffgehalten erhalten wurden, zur Herstellung der flüssigen Photopolymer-Zusammensetzungen verwendet.

### Beispiel 4 (Verwendung der Photoresistzusammensetzung entsprechend Beispiel 3 zur Strukturierung von Leiterplatten):

Es wurde ein Leiterplattenbasismaterial der Firma Allied Signal Norplex Oak, USA mit der Typenbezeichnung ED 130 verwendet, das beidseitig eine 18 µm dicke Kupferkaschierung aufwies (entsprechend US-Militär-Spezifikation MIL S 13949).

Das Basismaterial wurde nach dem nachfolgenden Verfahrensablauf behandelt:

| | | |
|---|---|---|
| 1. Vorbehandeln | a- Ätzreinigen mit Scheretch M | |
| | (Produkt der Firma Atotech | |
| | Deutschland GmbH, Berlin, DE) | 20 - 25 °C |
| | b- Spülen mit Wasser | 25 °C |
| | c- Dekapieren mit H₂SO₄ | 25 °C |
| | d- Spülen mit Wasser | 25 °C |
| | e- Trocknen mit Druckluft | |
| | f- Trocknen im Umluftofen (5 min) | 80 °C |
| | | |
| 2. Beschichten | Spin Coating Aufgeschleuderte Schichtdicke: 2,5 µm bis 4,5 µm | |
| 3. Trocknen | Auf der Heizplatte (2 min) | 100 °C |
| | oder im Umluftofen (5 min) | 80 °C oder 100 °C |
| | | |
| 4. Belichten | Belichter der Firma FSL, Großbritannien, Typ T 5000 Wellenlänge 365 nm (i-Linie) Lichtintensität 20 mJ/cm² bis 60 mJ/cm² | |
| | Layout: Auflösungsstrichtest-Maske Nr. 31 der Firma Haidenhain, Deutschland | |
| | | |
| 5. Nachbrennen | Auf der Heizplatte oder im Umluftofen 3 min bis 20 min | 80 - 120°C |
| | | |
| 6. Entwickeln | In einer Sprühanlage mit einer 1 Gew.-%igen Na₂CO₃-Lösung (1 min bis 3 min) | 30 °C |
| | | |
| 7. Kupfer-Ätzen | Saure Eisen-(III)-Chlorid-Ätzlösung (105 sec bis 3 min) | 40 °C |
| | | |
| 8. Entschichten | In einer Sprühanlage mit einer 1,8 Gew.-%igen NaOH-Lösung | 55 °C |

Unter Verwendung eines nach Beispiel 3 hergestellten Resists mit den in Tabelle 1 angegebenen Polymerzusammensetzungen wurde eine optische Auflösung entsprechend Tabelle 2 erreicht. In den nach dem Entwickeln entstandenen Kanälen in der Photoresiststruktur waren keine Rückstände mehr erkennbar. Nach dem Ätzen der freigelegten Kupferflächen (Verfahrensschritt 7.) und nachfolgendem Entschichten des Resists (Verfahrensschritt 8.) wurde ein Kupfermuster mit hochaufgelösten Strukturen erhalten.

### Beispiel 5:

Dasselbe Ergebnis wurde mit Resisten mit den Zusammensetzungen gemäß Tabelle 1, die analog Beispiel 2 aus der Reaktionslösung hergestellt wurden, erreicht. Hierzu wurde jeweils eine Polymerlösung nach Beispiel 2 hergestellt und gemäß Beispiel 3 mit NIT und AM zu einer Photoresist-Zusammensetzung gemischt.

Unter den Bedingungen des Verfahrensablaufes nach Beispiel 4, wobei die belichtete Resistschicht 20 min lang bei 80 °C nachgebrannt wurde, wurde ebenfalls eine sehr gute optische Auflösung der gebildeten Strukturen erhalten. In den Kanälen waren nach dem Entwickeln keine Resistrückstände mehr vorhanden.

### Vergleichsversuch V1:

Mit einem Polymeren der Zusammensetzung

| | |
|---|---|
| 17,6 Mol-% | Methacrylsäure, |
| 21,4 Mol-% | tert.-Butylmethacrylat, |
| 61 Mol-% | Methylmethacrylat |

wurde eine flüssige Photoresist-Zusammensetzung hergestellt, indem 30 Gewichtsteile NIT und 20 Gewichtsteile AM, jeweils je 1000 Gewichtsteile Polymerlösung, in einer 25 Gew.-%igen Polymerlösung in Propylenglykolmonomethylether gelöst wurden.

Der Photoresist wurde nach dem Verfahrensablauf gemäß Beispiel 4 auf ein Leiterplatten-Basismaterial aufgebracht und strukturiert. Nach dem Entwickeln wurde in den Resistkanälen noch eine geschlossene dünne Resistschicht gefunden. Dadurch konnte das darunterliegende Kupfer nicht bzw. nur sehr unvollständig durch die Ätzlösung entfernt werden.

Erst durch eine Verlängerung der Entwicklungszeit, Verwendung einer stärker konzentrierten Entwicklerlösung, Erhöhung der Entwicklungstemperatur bzw. Kombination dieser Maßnahmen konnte dieser festhaftende Resistfilm zumindest teilweise durchbrochen werden. Jedoch war das Ätzergebnis auch in diesem Falle unbefriedigend, da die Ätzlösung wegen der teilweise noch vorhandenen Resistschichten das Kupfer nicht ungehindert angreifen konnte. Außerdem waren die Kupferoberflächen in den Resistkanälen durch den intensiveren Angriff der Entwicklerlösung teilweise passiviert, so daß die Kupferflächen auch von daher schlechter ätzbar waren.

Der Versuch wurde mit Polymeren mit den folgenden Zusammensetzungen wiederholt:

| | |
|---|---|
| 1. | 2,1 Mol-% Acrylsäure, |
| | 30,7 Mol-% tert.-Butylmethacrylat, |
| | 33,6 Mol-% Methylmethacrylat, |
| | 33,6 Mol-% Ethylacrylat; |
| | |
| 2. | 20,5 Mol-% Methacrylsäure, |
| | 31,0 Mol-% tert.-Butylmethacrylat, |
| | 48,5 Mol-% Methylmethacrylat. |

Es wurden auch in diesen Fällen keine ausreichend guten Ergebnisse beim Entwickeln der Resistschichten erhalten: Es stellte sich heraus, daß in den Resistkanälen noch Reste des Resists zurückblieben, die beim Entwickeln nicht vollständig entfernt werden konnten.

### Beispiel 6 (Walzenauftragsverfahren für den Photoresist):

Mittels einer Walzenauftragsvorrichtung wurden flüssige Photoresistzusammensetzungen, hergestellt gemäß Beispiel 3 aus den Polymeren C, J und P (siehe auch Tabelle 1), auf die Kupferoberflächen von Leiterplattenbasismaterial-Zuschnitten (25 cm x 37,5 cm) aufgebracht.

Hierzu wurden zum einen 1,5 mm dicke FR 4-Platten der Firma Circuit-Foil, USA und 1,0 mm dicke Platten der Firma Fukuda, Japan eingesetzt. Beide Typen wiesen auf beiden Seiten 17,5 Am dicke Kupferkaschierungen auf.

Der Verfahrensablauf zur Behandlung der Leiterplatten ist im folgenden dargestellt:

| | | |
|---|---|---|
| 1. Vorbehandeln | a- Ätzreinigen mit einer Lösung aus Na₂S₂O₈ und H₂SO₄ (0,5 min) | 25 °C |
| | b- Spülen mit Wasser (0,5 min) | 25 °C |
| | c- Trocknen in Luft (ca. 1 min) | |
| 2. Beschichten | Walzenbeschichten oder Spin Coating Schichtdicke 4 µm bis 6 µm | |
| | | |
| 3. Trocknen | Im Umluftofen (5 min) | 100 °C |
| | | |
| 4. Belichten | Belichter der Firma Tamarack, Wellenlänge 365 nm (i-Linie) Lichtintensität 10 mJ/cm² bis 150 mJ/cm² | |
| | | |
| 5. Nachbrennen | Im Umluftofen 5 min bis 20 min | 80 - 120°C |
| | | |
| 6. Entwickeln | In einer Sprühanlage mit einer 1 Gew.-%igen Na₂CO₃-Lösung (2 min) | 30 °C |
| | | |
| 7. Kupfer-Ätzen | a- Saure Kupfer-(II)-chlorid-Ätzlösung (70 sec) | 50 °C |
| | b- Sauer Spülen | |
| | c- Spülen mit Wasser (0,5 min) | |
| | | |
| 8. Entschichten | In einer Sprühanlage mit einer 1,8 Gew.-%igen NaOH-Lösung (1,5 min) | 55 °C |

Es wurden die in Tabelle 3 dargestellten Ergebnisse erhalten. Es wurden höchstaufgelöste Strukturen nach dem Entwickeln des Resists erreicht. In den Resistkanälen befanden sich keine Rückstände des Resists mehr.

### Vergleichsversuch V2:

Der Versuch von Beispiel 6 wurde wiederholt. Anstelle der dort verwendeten Resiste wurden jedoch die Resiste von Vergleichsversuch V1 mit einem Polymeren, gebildet aus

| | |
|---|---|
| 17,6 Mol-% | Methacrylsäure, |
| 21,4 Mol-% | tert.-Butylmethacrylat, |
| 61,0 Mol-% | Methylmethacrylat, |

verwendet. In Tabelle 4 sind die Versuchsbedingungen angegeben.

Es konnten keine verwertbaren Ergebnisse erhalten werden. In den beim Entwickeln entstandenen Resistkanälen waren noch Resistreste vorhanden, die auch durch einen intensiveren Entwicklungsprozeß nicht entfernt werden konnten.

### Beispiel 7 (Additivtechnik):

Eine erfindungsgemäße Photoresist-Zusammensetzung, gebildet aus 20 Gew.-% des Polymeren J, 0,6 Gew.-% N-Trifluoromethylsulfonyloxynaphthalimid (NIT) als Säuregenerator und 0,4 Gew.-% 9-Anthracenmethanol (AM) als Photosensibilisator in Propylenglykolmonomethyletheracetat wurde auf ein Kunststoffteil aus Acrylnitril-Butadien-Styrol-Copolymerisat (ABS) aufgeschleudert, das zuvor mittels einer Chrom/Schwefelsäure-Beizlösung vorbehandelt, mit einem Aktivator (Noviganth ® AK I der Firma Atotech Deutschland GmbH) aktiviert und der Lösung Noviganth ® AK II der Firma Atotech Deutschland GmbH fixiert worden war. Die Photoresistzusammensetzung wurde alternativ auch durch eine Walzenauftragstechnik auf das ABS-Teil aufgebracht. Die Dicke der Resistschicht lag bei 3 µm bis 20 µm.

Anschließend wurde die Resistschicht mit einer Lichtintensität von 71 mJ/cm² bis 94 mJ/cm² durch eine Photomaske hindurch belichtet und danach in einem Umluftofen 10 Minuten lang bei einer Temperatur von 100 °C nachgebrannt. Das Musterteil wurde mit einer 1 Gew.-%igen Na₂CO₃-Lösung bei 30 °C entwickelt.

In den 100 µm breiten Strukturen in der Resistschicht wurde auf die mit dem Noviganth ®-Aktivator gebildeten Palladiumkeime eine Nickelschicht innerhalb von 3 bis 4 Minuten bei 45 °C bis 50 °C aus einem stromlosen Nickelbad (Noviganth ® TC der Firma Atotech Deutschland GmbH) abgeschieden. Auf der Nickelschicht wurde ferner eine Zinn/Blei-Legierungsschicht innerhalb von 5 bis 6 Minuten bei 35 °C elektrolytisch abgeschieden (Sulfolyt ® Tc der Firma Atotech Deutschland GmbH).

Anschließend wurde die Resistschicht mittels einer 5 Gew.-%igen Kaliumhydroxidlösung wieder vollständig von dem ABS-Teil entfernt. Zur Beschleunigung der Entschichtung wurde der Kaliumhydroxidlösung auch Butyldiglykol hinzugefügt.

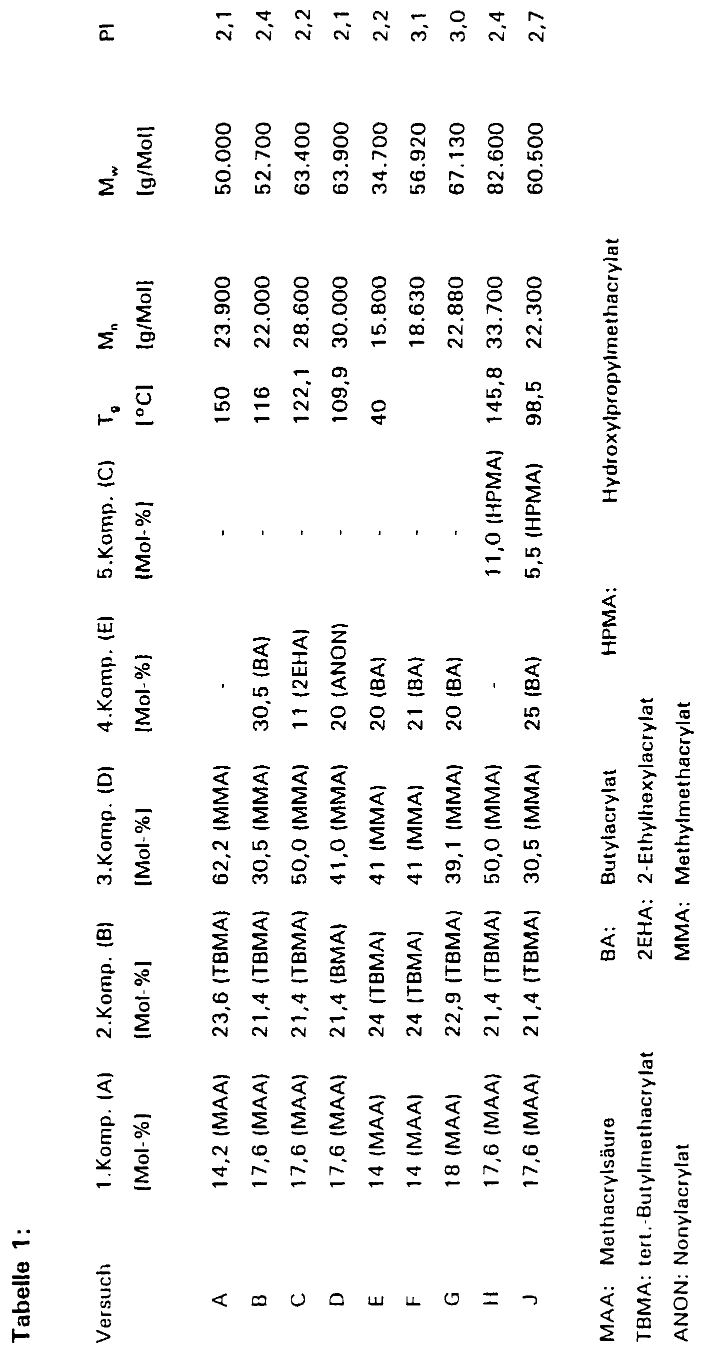

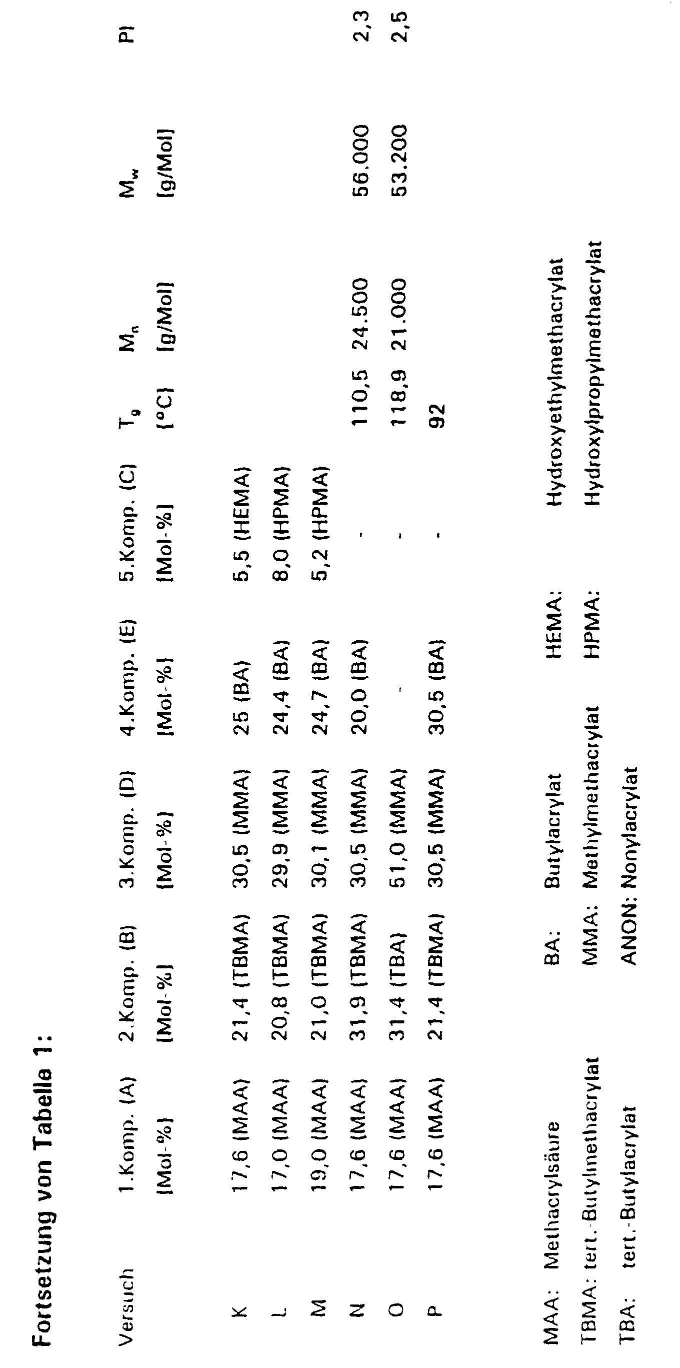

**Tabelle 2**

| (Optische Auflösung nach dem Entwickeln der mittels Spin-Coating-Verfahren aufgeschleuderten Photoresistschichten): | | | | | |
|---|---|---|---|---|---|
| Die optischen Auflösungswerte wurden an Testmustern mit einem Linien/Zwischenraum-Verhältnis von 1:1 erhalten. | | | | | |

| Versuch | Belichten Energiedichte [mJ/cm²] | Nachbrennen | | Entwickeln Behandl.zeit [min] | Optische Auflösung [µm] |
|---|---|---|---|---|---|
| | | Temperatur [°C] | Behandl.zeit [min] | | |
| Resist A: | | | | | |
| A1 | 20 | 120 | 3 | 1 | 25 |
| A3 | 20 | 110 | 10 | 1 | 32 |
| A4 | 40 | 110 | 10 | 1 | 32 |
| A6 | 21 | 80 | 20 | 2 | 20 |
| | | | | | |

| Resist B: | | | | | |
|---|---|---|---|---|---|
| B1 | 20 | 110 | 10 | 1 | 32 |
| B2 | 20 | 110 | 10 | 3 | 32 |
| B3 | 40 | 110 | 10 | 1 | 32 |
| B4 | 38 | 80 | 20 | 2 | 25 |
| | | | | | |

| Resist C: | | | | | |
|---|---|---|---|---|---|
| C2 | 40 | 110 | 10 | 1 | 16 |
| C4 | 40 | 80 | 20 | 2 | 20 |
| | | | | | |

| Resist D: | | | | | |
|---|---|---|---|---|---|
| D1 | 20 | 110 | 10 | 1 | 20 |
| D2 | 20 | 110 | 10 | 3 | 32 |
| D3 | 40 | 110 | 10 | 1 | 32 |
| | | | | | |

| Resist E: | | | | | |
|---|---|---|---|---|---|
| E1 | 40 | 100 | 5 | 1 | 40 |
| E2 | 38 | 80 | 20 | 2 | 16 |
| E3 | 19 | 80 | 20 | 2 | 12 |
| E4 | 19 | 90 | 10 | 2 | 16 |
| | | | | | |

| Resist F: | | | | | |
|---|---|---|---|---|---|
| F1 | 16 | 80 | 20 | 2,5 | 25 |
| F2 | 30 | 80 | 20 | 2,5 | 32 |
| | | | | | |

| Resist G: | | | | | |
|---|---|---|---|---|---|
| G1 | 16 | 80 | 20 | 2,5 | 25 |
| G2 | 30 | 80 | 20 | 2,5 | 40 |
| | | | | | |

| Resist H: | | | | | |
|---|---|---|---|---|---|
| H | 21 | 110 | 5 | 1 | 20 |
| | | | | | |

| Resist J: | | | | | |
|---|---|---|---|---|---|
| J1 | 21 | 110 | 10 | 1 | 10 |
| J2 | 21 | 110 | 10 | 3 | 16 |
| J3 | 40 | 110 | 10 | 1 | 16 |
| J4 | 40 | 110 | 10 | 3 | 20 |
| | | | | | |

| Resist K: | | | | | |
|---|---|---|---|---|---|
| K1 | 16 | 80 | 20 | 2,5 | 20 |
| K2 | 30 | 80 | 20 | 2,5 | 32 |
| K3 | 40 | 80 | 20 | 2,5 | 40 |
| | | | | | |

| Resist L: | | | | | |
|---|---|---|---|---|---|
| L1 | 30 | 80 | 20 | 2,5 | 25 |
| L2 | 40 | 80 | 20 | 2,5 | 40 |
| | | | | | |

| Resist M: | | | | | |
|---|---|---|---|---|---|
| M1 | 16 | 80 | 20 | 2,5 | 60 |
| M2 | 30 | 80 | 20 | 2,5 | 20 |
| | | | | | |

| Resist N: | | | | | |
|---|---|---|---|---|---|
| N1 | 20 | 110 | 10 | 1 | 12 |
| N2 | 20 | 110 | 10 | 3 | 12 |
| N3 | 40 | 110 | 10 | 1 | 12 |
| N4 | 40 | 110 | 10 | 3 | 32 |
| N5 | 40 | 100 | 5 | 1 | 10 |
| N6 | 40 | 80 | 20 | 2,5 | 32 |
| | | | | | |

| Resist O: | | | | | |
|---|---|---|---|---|---|
| O | 20 | 110 | 10 | 1 | 16 |

**Tabelle 3**

| (Optische Auflösung nach dem Entwickeln der mittels Walzenauftragsverfahren aufgebrachten Photoresistschichten): | | | | |
|---|---|---|---|---|
| Versuch | Belichten Energiedichte [mJ/cm²] | Nachbrennen | | Optische Auflösung [µm] |
| | | Temperatur [°C] | Behandl.zeit [min] | |
| Resist C: | | | | |
| C1 | 95 | 80 | 20 | 20 |
| C2 | 18 | 100 | 10 | 8 |
| C3 | 37 | 100 | 10 | 12 |
| C4 | 55 | 100 | 10 | 20 |
| C5 | 18 | 100 | 20 | 10 |
| C6 | 37 | 100 | 20 | 16 |
| | | | | |

| Resist J: | | | | |
|---|---|---|---|---|
| J1 | 37 | 80 | 10 | 6,3 |
| J2 | 55 | 80 | 10 | 6,3 |
| J3 | 37 | 80 | 20 | 12 |
| J4 | 55 | 80 | 20 | 16 |
| J5 | 9 | 100 | 5 | 4 |
| J6 | 18 | 100 | 5 | 6,3 |
| J7 | 37 | 100 | 5 | 10 |
| J8 | 55 | 100 | 5 | 12 |
| J9 | 94 | 100 | 5 | 16 |
| | | | | |

| Resist P: | | | | |
|---|---|---|---|---|
| P1 | 55 | 80 | 20 | 3 |
| P2 | 37 | 100 | 10 | 4 |
| P3 | 55 | 100 | 10 | 6 |
| P4 | 37 | 100 | 20 | 6 |

**Tabelle 4**

| (Optische Auflösung nach dem Entwickeln der mittels Walzenauftragsverfahren aufgebrachten Photoresistschichten von Vergleichsversuch V2): | | | | |
|---|---|---|---|---|
| Versuch | Belichten Energiedichte [mJ/cm²] | Nachbrennen | | Optische Auflösung [µm] |
| | | Temperatur [°C] | Behandl.zeit [min] | |
| I | 37 | 80 | 20 | Kein Bild |
| II | 55 | 100 | 10 | 6,3/ nicht ätzbar |
| III | 147 | 100 | 20 | 16/ nicht ätzbar |

## Patentansprüche

1. Photoempfindliche, durch Belichtung von einem in Entwicklungslösungen unlöslichen in einen löslichen Zustand überführbare Zusammensetzung, enthaltend
I - mindestens einen Photosäuregenerator und
II - Polymere, gebildet aus folgenden auf das Polymer bezogenen Anteilen an Monomeren:
A - Monomere, ausgewählt aus der Gruppe der Verbindungen Acrylsäure und Methacrylsäure, mit einem Anteil von 8 Mol-% bis 20 Mol-%,
B - Monomere, ausgewählt aus der Gruppe der Verbindungen tert.-Butylacrylat und tert.-Butylmethacrylat, mit einem Anteil von 19 Mol-% bis 70 Mol-% und
C - Monomere, ausgewählt aus der Gruppe der Verbindungen Hydroxyethylmethacrylat, Hydroxypropylmethacrylat, Hydroxyphenylmethacrylat, Hydroxyethylacrylat, Hydroxypropylacrylat und Hydroxyphenylacrylat, mit einem Anteil von 1 Mol-% bis 30 Mol-%.

2. Zusammensetzung nach Anspruch 1, gekennzeichnet durch
D - zusätzliche Monomere, ausgewählt aus der Gruppe der Verbindungen Methylacrylat und Methylmethacrylat, mit einem Anteil von 10 Mol-% bis 60 Mol-%.

3. Zusammensetzung nach Anspruch 2, gekennzeichnet durch
E - zusätzliche Monomere, ausgewählt aus der Gruppe der Verbindungen mit der allgemeinen Formel
CH₂ =CR¹-COOR²,
wobei
R¹ ein Wasserstoffatom oder eine Methylgruppe und
R² eine lineare oder verzweigte Alkylgruppe mit mindestens drei Kohlenstoffatomen ist,
mit einem Anteil von 3 Mol-% bis 35 Mol-%.

4. Photoempfindliche, durch Belichtung von einem in Entwicklungslösungen unlöslichen in einen löslichen Zustand überführbare Zusammensetzung, enthaltend
I- mindestens einen Photosäuregenerator und
II - Polymere, gebildet aus folgenden auf das Polymer bezogenen Anteilen an Monomeren:
A - Monomere, ausgewählt aus der Gruppe der Verbindungen Acrylsäure und Methacrylsäure, mit einem Anteil von 10 Mol-% bis 25 Mol-%,
B - Monomere, ausgewählt aus der Gruppe der Verbindungen tert.-Butylacrylat und tert.-Butylmethacrylat, mit einem Anteil von 17 Mol-% bis 40 Mol-%,
D - Monomere, ausgewählt aus der Gruppe der Verbindungen Methylacrylat und Methylmethacrylat, mit einem Anteil von 20 Mol-% bis 60 Mol-% und
E - Monomere, ausgewählt aus der Gruppe der Verbindungen mit der allgemeinen Formel
CH₂ =CR¹-COOR²,
wobei
R¹ ein Wasserstoffatom oder eine Methylgruppe und
R² eine lineare oder verzweigte Alkylgruppe mit mindestens fünf Kohlenstoffatomen ist,
mit einem Anteil von 1 Mol-% bis 35 Mol-%.

5. Photoempfindliche, durch Belichtung von einem in Entwicklungslösungen unlöslichen in einen löslichen Zustand überführbare Zusammensetzung, enthaltend
I- mindestens einen Photosäuregenerator und
II - Polymere, gebildet aus folgenden auf das Polymer, bezogenen Anteilen an Monomeren:
A - Monomere, ausgewählt aus der Gruppe der Verbindungen Acrylsäure und Methacrylsäure, mit einem Anteil von 14 Mol-% bis 20 Mol-%,
B - Monomere, ausgewählt aus der Gruppe der Verbindungen tert.-Butylacrylat und tert.-Butylmethacrylat, mit einem Anteil von 20 Mol-% bis 32 Mol-%,
D - Monomere, ausgewählt aus der Gruppe der Verbindungen Methylacrylat und Methylmethacrylat, mit einem Anteil von 30 Mol-% bis 50 Mol-% und
E - Monomere, ausgewählt aus der Gruppe der Verbindungen mit der allgemeinen Formel
CH₂ = CR¹-COOR²,
wobei
R¹ ein Wasserstoffatom oder eine Methylgruppe und
R² eine lineare oder verzweigte Alkylgruppe mit mindestens zwei Kohlenstoffatomen ist, und
die Monomeren E mit den Monomeren B nicht identisch sind,
mit einem Anteil von 10 Mol-% bis 40 Mol-%,
wobei die Summe der Anteile der Monomere A, B, D und E im Polymer 100 Mol-% beträgt.

6. Photoempfindliche, durch Belichtung von einem in Entwicklungslösungen unlöslichen in einen löslichen Zustand überführbare Zusammensetzung, enthaltend
I - mindestens einen Photosäuregenerator und
II - Polymere, gebildet aus folgenden auf das Polymer bezogenen Anteilen an Monomeren:
A - Monomere, ausgewählt aus der Gruppe der Verbindungen - Acrylsäure und Methacrylsäure, mit einem Anteil von 13 Mol-% bis 15 Mol-%,
B - Monomere, ausgewählt aus der Gruppe der Verbindungen tert.-Butylacrylat und tert.-Butylmethacrylat, mit einem Anteil von 22,5 Mol-% bis 30 Mol-% und
D - Monomere, ausgewählt aus der Gruppe der Verbindungen Methylacrylat und Methylmethacrylat, mit einem Anteil von 50 Mol-% bis 65 Mol-%,
wobei die Summe der Anteile der Monomere A, B und D im Polymer 100 Mol-% beträgt.

7. Zusammensetzung nach einem der vorstehenden Ansprüche, gekennzeichnet durch ein mittleres Molekulargewicht M_{w} der Polymere von 30.000 bis 90.000, vorzugsweise von 35.000 bis 82.000, und mit einem Polymolekularitätsindex Pl von 1,6 bis 3,1, vorzugsweise von 2,1 bis 3,0.

8. Zusammensetzung nach einem der vorstehenden Ansprüche, gekennzeichnet durch einen Gehalt des Photosäuregenerators von 1 Gew.-% bis 25 Gew.-%, vorzugsweise von 2 Gew.-% bis 20 Gew.-%, bezogen auf das Gewicht des Polymeren in der Zusammensetzung.

9. Zusammensetzung nach einem der vorstehenden Ansprüche, gekennzeichnet durch einen oder mehrere zusätzlich enthaltene Photosensibilisatoren.

10. Zusammensetzung nach einem der vorstehenden Ansprüche, gekennzeichnet durch einen Gehalt der Photosensibiiisatoren von 1 Gew.-% bis 6 Gew.-%, vorzugsweise von 2 Gew.-% bis 4 Gew.-%, bezogen auf das Gewicht des Polymeren in der Zusammensetzung.

11. Verwendung der Zusammensetzung nach einem der Ansprüche 1 bis 10 als Ätz- oder Galvanoresist zur Strukturierung von Metallschichten.

12. Verwendung nach Anspruch 11, gekennzeichnet durch mit Kupferflächen versehene Leiterplatten oder für Leiterplatten vorgesehene Innenlagen-Laminate sowie Polyimid/Kupfer-Laminate als elektrische Schaltungsträger.

## Claims

1. Photosensitive composition, which is convertible into a soluble state from a state which is insoluble in developing solutions by exposure, containing
I - at least one acidproof photogenerator and
II - polymers, formed from the following proportions of monomers relative to the polymer:
A - monomers, selected from the group of compounds acrylic acid and methacrylic acid, having a proportion of between 8 mol % and 20 mol %,
B - monomers, selected from the group of compounds tert. butyl acrylate and tert. butyl methacrylate, having a proportion of between 19 mol % and 70 mol %, and
C - monomers, selected from the group of compounds hydroxyethyl methacrylate, hydroxypropyl methacrylate, hydroxyphenyl methacrylate, hydroxyethyl acrylate, hydroxypropyl acrylate and hydroxyphenyl acrylate, having a proportion of between 1 mol % and 30 mol %.

2. Composition according to claim 1, characterised by
D - additional monomers, selected from the group of compounds methyl acrylate and methyl methacrylate, having a proportion of between 10 mol % and 60 mol %.

3. Composition according to claim 2, characterised by
E - additional monomers, selected from the group of compounds having the general formula
CH₂ = CR¹-COOR²,
wherein
R¹ is a hydrogen atom or a methyl group, and
R² is a linear or branched alkyl group having at least three carbon atoms,
and having a proportion of between 3 mol % and 35 mol %.

4. Photosensitive composition, which is convertible into a soluble state from a state which is insoluble in developing solutions by exposure, containing
I - at least one acidproof photogenerator and
II - polymers, formed from the following proportions of monomers relative to the polymer:
A - monomers, selected from the group of compounds acrylic acid and methacrylic acid, having a proportion of between 10 mol % and 25 mol %,
B - monomers, selected from the group of compounds tert. butyl acrylate and tert. butyl methacrylate, having a proportion of between 17 mol % and 40 mol %,
D - monomers, selected from the group of compounds methyl acrylate and methyl methacrylate, having a proportion of between 20 mol % and 60 mol %, and
E - monomers, selected from the group of compounds having the general formula
CH₂ = CR¹-COOR²,
wherein
R¹ is a hydrogen atom or a methyl group, and
R² is a linear or branched alkyl group having at least five carbon atoms,
and having a proportion of between 1 mol % and 35 mol %.

5. Photosensitive composition, which is convertible into a soluble state from a state which is insoluble in developing solutions by exposure, containing
I - at least one acidproof photogenerator and
II - polymers, formed from the following proportions of monomers relative to the polymer:
A - monomers, selected from the group of compounds acrylic acid and methacrylic acid, having a proportion of between 14 mol % and 20 mol %,
B - monomers, selected from the group of compounds tert. butyl acrylate and tert. butyl methacrylate, having a proportion of between 20 mol % and 32 mol %,
D - monomers, selected from the group of compounds methyl acrylate and methyl methacrylate, having a proportion of between 30 mol % and 50 mol %, and
E - monomers, selected from the group of compounds having the general formula
CH₂ = CR¹-COOR²,
wherein
R¹ is a hydrogen atom or a methyl group, and
R² is a linear or branched alkyl group having at least two carbon atoms, and
the monomers E are not identical to the monomers B,
and having a proportion of between 10 mol % and 40 mol %, the sum of the proportions of the monomers A, B, D and E in the polymer amounting to 100 mol %.

6. Photosensitive composition, which is convertible into a soluble state from a state which is insoluble in developing solutions by exposure, containing
I - at least one acidproof photogenerator and
II - polymers, formed from the following proportions of monomers relative to the polymer:
A - monomers, selected from the group of compounds acrylic acid and methacrylic acid, having a proportion of between 13 mol % and 15 mol %,
B - monomers, selected from the group of compounds tert. butyl acrylate and tert. butyl methacrylate, having a proportion of between 22.5 mol % and 30 mol %, and
D - monomers, selected from the group of compounds methyl acrylate and methyl methacrylate, having a proportion of between 50 mol % and 65 mol %,
the sum of the proportions of the monomers A, B and D in the polymer amounting to 100 mol %.

7. Composition according to one of the preceding claims, characterised by an average molecular weight M_{w} of the polymers of between 30,000 and 90,000, preferably between 35,000 and 82,000, and having a polymolecularity index PI of between 1.6 and 3.1, preferably between 2.1 and 3.0.

8. Composition according to one of the preceding claims, characterised by a content of the acidproof photogenerator of between 1 % by wt. and 25 % by wt., preferably between 2 % by wt. and 20 % by wt., relative to the weight of the polymer in the composition.

9. Composition according to one of the preceding claims, characterised by one or more additionally included photosensitizers.

10. Composition according to one of the preceding claims, characterised by a content of the photosensitizers of between 1 % by wt. and 6 % by wt., preferably between 2 % by wt. and 4 % by wt., relative to the weight of the polymer in the composition.

11. Use of the composition according to one of claims 1 to 10 as the etching or electroplating resist for the structuring of metal layers.

12. Use according to claim 11, characterised by printed circuit boards, which are provided with copper faces, or internal layer laminates, which are intended for printed circuit boards, as well as polyimide/copper laminates as electrical circuit carriers.

## Revendications

1. Composition photosensible, convertible par insolation d'un état insoluble à un état soluble dans une solution de développement, contenant
I) au moins un agent photo-acidogène, et
II) des polymères formés à partir des quantités de monomères suivantes, ramenées à la quantité du polymère :
A) des monomères choisis dans le groupe comprenant les composés acide acrylique et acide méthacrylique, en une quantité de 8% molaires à 20% molaires,
B) des monomères choisis dans le groupe comprenant les composés acrylate de tert.-butyle et méthacrylate de tert.-butyle, en une quantité de 19% molaires à 70% molaires, et
C) des monomères choisis dans le groupe comprenant les composés méthacrylate d'hydroxyéthyle, méthacrylate d'hydroxypropyle, méthacrylate d'hydroxyphényle, acrylate d'hydroxyéthyle, acrylate d'hydroxypropyle et acrylate d'hydroxyphényle, en une quantité de 1% molaires à 30% molaires.

2. Composition selon la revendication 1, caractérisée par
D) des monomères supplémentaires choisis dans le groupe comprenant les composés acrylate de méthyle et méthacrylate de méthyle, en une quantité de 10% molaires à 60% molaires.

3. Composition selon la revendication 2, caractérisée par
E) des monomères supplémentaires choisis dans le groupe comprenant les composés de la formule générale
CH₂=CR¹-COOR²,
dans laquelle
R¹ est un atome d'hydrogène ou un groupe méthyle, et
R² est un groupe alkyle linéaire ou ramifié ayant au moins trois atomes de carbone,
en une quantité de 3% molaires à 35% molaires.

4. Composition photosensible, convertible par insolation d'un état insoluble à un état soluble dans une solution de développement, contenant
I) au moins un agent photo-acidogène, et
II) des polymères formés à partir des quantités de monomères suivantes, ramenées à la quantité du polymère :
A) des monomères choisis dans le groupe comprenant les composés acide acrylique et acide méthacrylique, en une quantité de 10% molaires à 25% molaires,
B) des monomères choisis dans le groupe comprenant les composés acrylate de tert.-butyle et méthacrylate de tert.-butyle, en une quantité de 17% molaires à 40% molaires,
D) des monomères choisis dans le groupe comprenant les composés acrylate de méthyle et méthacrylate de méthyle, en une quantité de 20% molaires à 60% molaires, et
E) des monomères choisis dans le groupe comprenant les composés de la formule générale
CH₂=CR¹-COOR²,
dans laquelle
R¹ est un atome d'hydrogène ou un groupe méthyle, et
R² est un groupe alkyle linéaire ou ramifié ayant au moins cinq atomes de carbone,
en une quantité de 1% molaires à 35% molaires.

5. Composition photosensible, convertible par insolation d'un état insoluble à un état soluble dans une solution de développement, contenant
I) au moins un agent photo-acidogène, et
II) des polymères formés à partir des quantités de monomères suivantes, ramenées à la quantité du polymère :
A) des monomères choisis dans le groupe comprenant les composés acide acrylique et acide méthacrylique, en une quantité de 14% molaires à 20% molaires,
B) des monomères choisis dans le groupe comprenant les composés acrylate de tert.-butyle et méthacrylate de tert.-butyle, en une quantité de 20% molaires à 32% molaires,
D) des monomères choisis dans le groupe comprenant les composés acrylate de méthyle et méthacrylate de méthyle, en une quantité de 30% molaires à 50% molaires, et
E) des monomères choisis dans le groupe comprenant les composés de la formule générale
CH₂=CR¹-COOR²,
dans laquelle
R¹ est un atome d'hydrogène ou un groupe méthyle, et
R² est un groupe alkyle linéaire ou ramifié ayant au moins deux atomes de carbone, et
les monomères E ne sont pas identiques aux monomères B,
en une quantité de 10% molaires à 40% molaires,
la somme des quantités des monomères A, B, D et E dans le polymère étant égale à 100% molaires.

6. Composition photosensible, convertible par insolation d'un état insoluble à un état soluble dans une solution de développement, contenant
I) au moins un agent photo-acidogène, et
II) des polymères formés à partir des quantités de monomères suivantes, ramenées à la quantité du polymère :
A) des monomères choisis dans le groupe comprenant les composés acide acrylique et acide méthacrylique, en une quantité de 13% molaires à 15% molaires,
B) des monomères choisis dans le groupe comprenant les composés acrylate de tert.-butyle et méthacrylate de tert.-butyle, en une quantité de 22,5% molaires à 30% molaires, et
D) des monomères choisis dans le groupe comprenant les composés acrylate de méthyle et méthacrylate de méthyle, en une quantité de 50% molaires à 65% molaires,
la somme des quantités des monomères A, B et D dans le polymère étant égale à 100% molaires.

7. Composition selon l'une des revendications précédentes, caractérisée par un poids moléculaire moyen M_{W} des polymères de 30 000 à 90 000, de préférence 35 000 à 82 000, et par un indice de polymolécularité PI de 1,6 à 3,1, de préférence 2,1 à 3,0.

8. Composition selon l'une des revendications précédentes, caractérisée par une teneur en agent photo- acidogène de 1% en poids à 25% en poids, de préférence 2% en poids à 20% en poids, ramenée au poids du polymère dans la composition.

9. Composition selon l'une des revendications précédentes, caractérisée en ce qu'elle contient en plus un ou plusieurs agents photosensibilisants.

10. Composition selon l'une des revendications précédentes, caractérisée par une teneur en agents photosensibilisants de 1% en poids à 6% en poids, de préférence 2% en poids à 4% en poids, ramenée au poids du polymère dans la composition.

11. Utilisation de la composition selon l'une des revendications 1 à 10 comme épargne de gravure ou de galvanisation pour la structuration de couches métalliques.

12. Utilisation selon la revendication 11, caractérisée par des circuits imprimés munis de surfaces cuivrées ou par des stratifiés de couches internes prévues pour des circuits imprimés, ainsi que par des stratifiés de polyimide et de cuivre, en tant que supports de circuits électriques.
